# EUROPÄISCHE PATENTSCHRIFT

(11) **EP 0 675 531 B1**
(45) Veröffentlichungstag und Bekanntmachung des Hinweises auf die Patenterteilung: **14.06.2006**
(21) Anmeldenummer: 95103311.7
(22) Anmeldetag: 08.03.1995
(51) Int. Cl.: H01L 21/60, H05K 3/36, B23K 1/08, H01L 23/485, H05K 3/34

(54) **Verfahren zum elektrisch leitfähigen Verbinden von Kontakten**
Process for electrically interconnecting contacts
Procédé d'interconnection électrique de contacts

(30) Priorität: 28.03.1994 DE 4410739
(43) Veröffentlichungstag der Anmeldung: 04.10.1995
(73) Patentinhaber: ROBERT BOSCH GMBH, 70442 Stuttgart (DE)
(72) Erfinder: Becker, Rolf, Dr., D-72766 Reutlingen (DE)

(56) Entgegenhaltungen:
- EP-A- 0 322 121
- EP-A- 0 388 011
- EP-A- 0 485 760
- WO-A-92/06491
- F & M. FEINWERKTECHNIK MIKROTECHNIK MESSTECHNIK, Bd. 101, Nr. 7 / 08, 1.August 1993, Seiten 308-312, XP000387212 LIEDKE V: "WELLENLOETEN OHNE FLUSSMITTEL"
- PROCEEDINGS OF THE ELECTRONIC COMPONENTS AND TECHNOLOGY CONFERENCE, ORLANDO, JUNE 1 - 4, 1993, Nr. CONF. 43, 1.Juni 1993, INSTITUTE OF ELECTRICAL AND ELECTRONICS ENGINEERS, Seiten 992-996, XP000380102 MIKI MORI ET AL: "A FINE PITCH COG TECHNIQUE FOR A TFT-LCD PANEL USING AN INDIUM ALLOY"

## Beschreibung

### Stand der Technik

Die Erfindung geht aus von einem Verfahren zum elektrisch leitfähigen Verbinden von Kontakten nach der Gattung des Hauptanspruchs. Es ist bereits bekannt, Kontakte elektrisch leitfähig miteinander zu verbinden, indem einer der Kontakte mit Lot benetzt wird, dem ein Flußmittel beigefügt ist. Damit entsteht der Nachteil, daß durch das Flußmittel eine Korrosion stattfinden kann, die die mechanische Belastbarkeit der Lötverbindung herabsetzt. Außerdem verhindert das Flußmittel eine Haftung eines Klebstoffs an der Oberfläche der Schaltung, wodurch ebenfalls die mechanische Belastbarkeit der Lötverbindung gering ausfällt, da kein Klebstoff zur Belastbarkeitserhöhung vorgesehen werden kann.

### Vorteile der Erfindung

Das erfindungsgemäße Verfahren mit den kennzeichnenden Merkmalen des Hauptanspruchs hat demgegenüber den Vorteil, daß die Funktion der elektrischen Verbindung als auch der mechanischen Verbindung zweier Kontakte durch getrennte Verbindungsmittel erfolgt, wodurch die Gefahr der Reduzierung der Qualität der mechanischen Verbindung durch die elektrische Verbindung vermindert wird. Des weiteren tritt der Vorteil auf, daß sowohl die elektrische Verbindung als auch die mechanische Verbindung mittels spezieller Verbindungsmittel erfolgen kann, die sich erst durch den Verbindungsprozeß thermisch stabil ausbilden, so daß die Verbindung der beiden Schaltungen auch bei thermischer Belastung bestehen bleibt.

Das Überziehen des Kontaktes mit einer Nickelschicht ergibt den Vorteil einer metallurgisch stabileren Lötverbindung.

Das Überziehen des Kontaktes oder des weiteren Kontaktes mit einer Goldschicht bringt den Vorteil mit sich, daß eine nahezu blanke, oxidfreie Metalloberfläche für den Lötvorgang vorliegt. Dadurch wird die Benetzung mit flußmittelfreiem, elektrisch leitfähigem Lot erleichtert.

Sn63Pb, welches mittels Wellenlötung auf den Kontakt gebracht wird, stellt eine besonders vorteilhafte Auswahl als Lot dar, weil die Eigenschaften dieses Materials hinsichtlich Schmelzpunkt, Leitfähigkeit und thermischer Stabilität sowie Migrationsfestigkeit für die elektrische Verbindung gut geeignet sind. Durch die Wellenlötung wird der Kontakt nur mit einer definierten, sehr geringen Menge des Lots benetzt, so daß sich nach Herstellung der eigentlichen leitfähigen Verbindung durch Diffusion thermisch wesentlich stabilere Verbindungen ausbilden.

Durch die in den Unteransprüchen aufgeführten Maßnahmen sind vorteilhafte Weiterbildungen und Verbesserungen des im Hauptanspruch angegebenen Verfahrens möglich.

Die Verwendung eines kapillar fließfähigen Klebstoffs bringt den Vorteil mit sich, daß durch den selbsttätig eintretenden Fließvorgang eine gleichmäßige Verteilung des Klebstoffs in den Zwischenraum zwischen die beiden elektronischen Schaltungen erfolgt, wodurch die Haftkraft zwischen beiden Schaltungen zueinander vergrößert wird.

Ein weiterer Vorteil ist dadurch gegeben, daß wenigstens einer der ersten drei Verfahrensschritte in einer Schutzgas-Atmosphäre durchgeführt wird, da so eine Oxidation der Oberflächen der Kontakte verhindert werden kann und die Qualität der elektrischen Verbindung verbessert wird.

Die Verflüssigung des flußmittelfreien elektrisch leitfähigen Lots mittels Wärme oder Reibung stellt eine besonders aufwandsarme Realisierung des dritten Verfahrensschritts dar.

Die Verwendung eines Transportrahmens erleichtert die Handhabung der elektronischen Schaltung im ersten Verfahrensschritt.

Es erweist sich weiterhin als vorteilhaft, daß mehrere elektronische Schaltungen zusammen auf einem Transportrahmen befestigt werden, da sich so der Aufwand für mehrere Schaltungen reduziert.

Ein Ausführungsbeispiel der Erfindung ist in der Zeichnung dargestellt und in der nachfolgenden Beschreibung näher erläutert.

Es zeigen:
Figur 1 das Verfahren der Beschichtung der Kontakte der elektronischen Schaltung mittels Wellenlötung,
Figur 2 zwei übereinander liegende, miteinander verbundene elektronische Schaltungen.

### Beschreibung des Ausführungsbeispiels

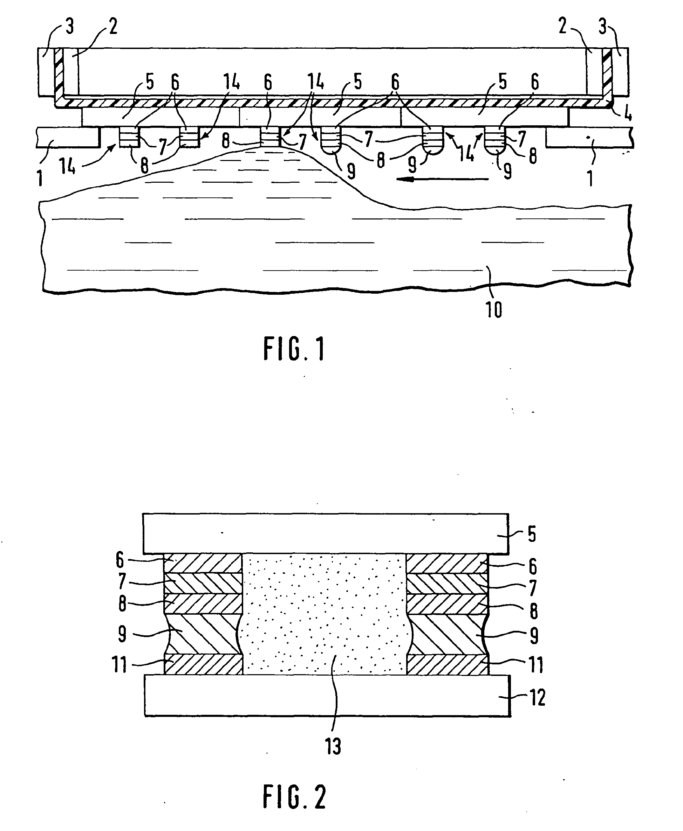

In Figur 1 ist ein Verfahren zur Beschichtung von Kontakten einer elektronischen Schaltung dargestellt. Ein hohlzylinderförmiger Innenrahmen 2 ist mit einer Trägerfolie 4 bespannt und in einen hohlyzlinderförmigen Außenrahmen 3 eingepaßt. Auf der Trägerfolie 4 sind mehrere elektronische Schaltungen 5 befestigt. Jede elektronische Schaltung 5 weist zwei Kontakte 14 auf, von denen jeder aus drei Schichten besteht. Eine unterste erste Metallschicht 6 wird von einer mittleren zweiten Metallschicht 7 bedeckt, die wiederum von einer oberen dritten Metallschicht 8 bedeckt ist. Die Anordnung aus Innenrahmen 2, Außenrahmen 3, Trägerfolie 4 sowie elektronischen Schaltungen 5 ist kopfüber auf einen Transportrahmen 1 gelegt, der eine Aussparung aufweist, durch die die Kontakte 14 der elektronischen Schaltungen 5 nach unten ragen. Unterhalb des Transportrahmens 1 befindet sich flüssiges Lot 10 in Form von Lötzinn. Durch Wellenanregung des Lots 10 wandert eine Lotwelle entlang der Unterseite des Transportrahmens 1 und berührt dabei die Oberflächen der oberen Metallschicht 8 der Kontakte 14. Dabei hinterläßt das Lot 10 Zinntropfen 9, die die dritte Metallschicht 8 jedes Kontakts 14 in Form eines flachen Hügels bedecken. Nach diesem Beschichtungsprozess wird der Transportrahmen 1 von dem Lötbad entfernt. Die elektronischen Schaltungen 5 werden dann auf weitere elektronische Schaltungen 12 gesetzt. Die weiteren elektronischen Schaltungen 12 weisen weitere Kontakte 11 auf und sind vorzugsweise auf einem stabilen Trägerelement befestigt.

In Figur 2 ist eine Verbindungsstelle zwischen zwei elektronischen Schaltungen 5, 12 dargestellt, wobei die Numerierung aus der Figur 1 beibehalten wurde. Nachdem die elektronische Schaltung 5 so über der weiteren elektronischen Schaltung 12 plaziert wurde, daß die Kontakte 14 über den weiteren Kontakten 11 der weiteren elektronischen Schaltung 12 liegen, werden die Kontakte 14 mit den Zinntropfen 9 unter Anwendung von leichten Rüttelbewegungen und einer erhöhten Temperatur auf die weiteren Kontakte 11 gedrückt, wodurch eine elektrisch leitfähige Verbindung zwischen den Kontakten 14 und den weiteren Kontakten 11 entsteht, indem sich das Lot im flüssigen Zustand mit der Oberfläche der weiteren Kontakte 11 verbindet. Zusätzlich wird zwischen den Kontakten 14 ein Klebstoff 13 eingefüllt, der durch die Kapillarwirkung des kleinen Spaltes zwischen den elektronischen Schaltungen 5, 12 in deren Zwischenraum fließt. Die Fließeigenschaften und die Haftung des Klebstoffs 13 an den Schaltungen 5, 12 werden vor allem nicht durch ein Flußmittel verringert.

Als erste Metallschicht 6 dient vorzugsweise Aluminium, als zweite Metallschicht 7 vorzugsweise Nickel, als dritte Metallschicht 8 vorzugsweise Gold. Der weitere Kontakt 11 besteht vorzugsweise ebenfalls aus Gold. Durch die spezielle Auswahl der Metalle sowie die geringe beim Wellenlöten auf den Kontakten 14 haften bleibende Menge des Lots 10 entsteht eine thermisch äußerst stabile elektrische Verbindung, da nur sehr wenig Material der dritten Metallschicht 8 und des weiteren Kontakts 11 in das Lot 10 eindiffundiert. Es bilden sich nämlich bei der Verwendung von Sn63Pb als Lot 10 und bei einem Aufbau der Kontakte 14 mit Aluminium, Nickel und Gold die temperaturstabilen NiSn-, AuPb- und AuSn-Phasen.

Zur Verbesserung des erfindungsgemäßen Verfahrens kann jeder der ersten drei Verfahrensschritte (Benetzen, Aufsetzen, Verbinden) unter einer Schutzgas-Atmosphäre, wozu jedes reduzierende Gas (z.B. Stickstoff) geeignet ist, stattfinden.

Dadurch verringert sich der Oxydanteil der Metalloberfläche, was eine qualitative Verbesserung der elektrischen Verbindung zwischen weiterem Kontakt 11 und Kontakt 14 bewirkt. Das erfindungsgemäße Verfahren ist insbesondere für die Herstellung von Flip-Chip-Verbindungen geeignet.

## Patentansprüche

1. Verfahren zum elektrisch leitfähigen Verbinden wenigstens eines Kontakts einer elektronischen Schaltung mit wenigstens einem weiteren Kontakt einer weiteren elektronischen Schaltung, wobei in einem ersten Verfahrensschritt der wenigstens eine Kontakt (14) mit einer Goldschicht (8) überzogen wird, und mit einem verflüssigten, elektrisch leitfähigen, flußmittelfreien Lot (10) beschichtet wird und in einem zweiten Verfahrensschritt die elektronische Schaltung (5) so auf die weitere elektronische Schaltung (12) aufgesetzt wird, daß der mit dem Lot (10) beschichtete Kontakt (14) und der weitere Kontakt (11) übereinander zu liegen kommen und in einem dritten Verfahrensschritt das elektrisch leitfähige, flußmittelfreie Lot (10) in flüssigem Zustand mit dem weiteren Kontakt (11) elektrisch leitfähig verbunden wird und dann verfestigt wird, **dadurch gekennzeichnet, daß** der Kontakt (14) vor dem überziehen der Goldschicht mit einer Nickelschicht (7) überzogen wird, daß als elektrisch leitfähiges Lot (10) Sn63Pb mittels Wellenlötung auf den Kontakt (14) gebracht wird und daß nach dem dritten Verfahrensschritt in einem vierten Verfahrensschritt zwischen die beiden elektronischen Schaltungen (5, 12) ein verflüssigtes, aushärtbares, nichtleitendes Verbindungsmittel (13) eingebracht wird.

2. Verfahren nach Anspruch 1, **dadurch gekennzeichnet, daß** als nichtleitendes Verbindungsmittel (13) ein kapillar fließfähiger Klebstoff verwendet wird.

3. Verfahren nach Anspruch 1 oder 2, **dadurch gekennzeichnet, daß** wenigstens einer der ersten drei Verfahrensschritte in einer Schutzgas-Atmosphäre durchgeführt wird.

4. Verfahren nach einem der Ansprüche 1 bis 3, **dadurch gekennzeichnet, daß** im dritten Verfahrensschritt das elektrisch leitfähige Lot (10) mittels Wärme und/oder Reibung verflüssigt wird.

5. Verfahren nach einem der Ansprüche 1 bis 4, **dadurch gekennzeichnet, daß** der weitere Kontakt (11) vor dem ersten Verfahrensschritt mit einer Goldschicht (8) überzogen wird.

6. Verfahren nach einem der Ansprüche 1 bis 5, **dadurch gekennzeichnet, daß** die elektronische Schaltung (5) vor dem ersten Verfahrensschritt auf einem Transportrahmen (1) befestigt wird.

7. Verfahren nach Anspruch 6, **dadurch gekennzeichnet, daß** mehrere elektronische Schaltungen (5) zusammen auf einem gemeinsamen Transportrahmen (1) befestigt werden.

## Claims

1. Method for electrically conductively connecting at least one contact of an electronic circuit to at least one further contact of a further electronic circuit, in which, in a first method step, the at least one contact (14) is covered with a layer of gold (8), and is coated with a liquefied, electrically conductive, flux-free solder (10), and in a second method step the electronic circuit (5) is placed onto the further electronic circuit (12), in such a way that the contact (14) which has been coated with the solder (10) and the further contact (11) come to lie above one another, and in a third method step the electrically conductive, flux-free solder (10) is electrically conductively connected in the liquid state to the further contact (11) and is then solidified, **characterized in that** the contact (14), before it is covered with the layer of gold, is covered with a layer of nickel (7), **in that** Sn63Pb is applied to the contact (14) by means of wave soldering as the electrically conductive solder (10), and **in that** in a fourth method step following the third method step, a liquefied curable, nonconductive joining agent (13) is introduced between the two electronic circuits (5, 12).

2. Method according to Claim 1, **characterized in that** the nonconductive joining agent (13) used is an adhesive with capillary flow.

3. Method according to Claim 1 or 2, **characterized in that** at least one of the first three method steps is carried out in a protective gas atmosphere.

4. Method according to one of Claims 1 to 3, **characterized in that** in the third method step the electrically conductive solder (10) is liquefied by means of heat and/or friction.

5. Method according to one of Claims 1 to 4, **characterized in that** the further contact (11) is covered with a layer of gold (8) prior to the first method step.

6. Method according to one of Claims 1 to 5, **characterized in that** the electronic circuit (5) is secured to a transporting frame (1) prior to the first method step.

7. Method according to Claim 6, **characterized in that** a plurality of electronic circuits (5) are jointly secured to one common transporting frame (1).

## Revendications

1. Procédé de liaison électroconductrice d'au moins un contact d'un circuit électronique avec au moins un autre contact d'un autre circuit électronique, selon lequel dans une première étape de procédé, on recouvre un contact (14) d'une couche d'or (8) et d'un métal de brasage (10) liquéfié d'électroconducteur et exempt de flux décapant, et dans une deuxième étape de procédé, on met en place le circuit électronique (5) sur l'autre circuit électronique (12) de telle sorte que le contact (14) revêtu du métal de brasage (10) et l'autre contact (11) viennent reposer l'un sur l'autre, tandis que dans une troisième étape de procédé, on relie le métal de brasage (10) électroconducteur et exempt de flux décapant, à l'état liquide, avec l'autre contact (11) de manière électroconductrice puis on le solidifie,
**caractérisé en ce qu'**
avant le recouvrement avec la couche d'or, on recouvre le contact (14) d'une couche de nickel (7), on applique du Sn63Pb comme métal de brasage (10) électroconducteur sur le contact (14) au moyen d'un brasage à la vague et après la troisième étape de procédé, dans une quatrième étape de procédé, on introduit entre les deux circuits électroniques (5, 12) un moyen de liaison (13) liquéfié, durcissable et non conducteur.

2. Procédé selon la revendication 1,
**caractérisé en ce que**
comme moyen de liaison non conducteur (13) on utilise un adhésif pouvant s'écouler par capillarité.

3. Procédé selon la revendication 1 ou 2,
**caractérisé en ce qu'**
au moins l'une des trois premières étapes de procédé est réalisée sous une atmosphère de gaz de protection.

4. Procédé selon l'une des revendications 1 à 3,
**caractérisé en ce que**
dans la troisième étape de procédé, on liquéfie le métal de brasage conducteur d'électricité (10) par apport de chaleur et/ou par frottement.

5. Procédé selon l'une des revendications 1 à 4,
**caractérisé en ce qu'**
avant la première étape de procédé, on recouvre l'autre contact (11) d'une couche d'or (8).

6. Procédé selon l'une des revendications 1 à 5,
**caractérisé en ce qu'**
avant la première étape de procédé, on fixe le circuit électronique (5) sur un châssis de transport (1).

7. Procédé selon la revendication 6,
**caractérisé en ce qu'**
on fixe plusieurs circuits électroniques (5) ensemble sur un châssis de transport commun (1).
